# EUROPEAN PATENT APPLICATION

(11) **EP 4 007 168 A1**
(43) Date of publication of application: **01.06.2022**
(21) Application number: 21204750.0
(22) Date of filing: 26.10.2021
(51) Int. Cl.: H03K 5/24

(54) **LOW NOISE HYBRID COMPARATOR**

(30) Priority: 30.11.2020 US 202017106456
(71) Applicant: Renesas Electronics America Inc., Milpitas, California 95035 (US)
(72) Inventor: LEE, Soonseob, Seoul 06178 (KR); HAN, Kwang-Seok, Seoul 06178 (KR); HA, Jong Chan, Seoul 06178 (KR); CHO, Ilhyun, Seoul 06178 (KR); SUH, Heewon, Seoul 06178 (KR); JIN, Hyunbae, Seoul 06178 (KR); LEEM, You Ho, Seoul 06178 (KR); LEE, Seunghun, Seoul 06178 (KR); OH, Kwang Hoon, Seoul 06178 (KR)
(74) Representative: Lippert Stachow Patentanwälte Rechtsanwälte Partnerschaft mbB

(57) **Abstract**

A hybrid comparator includes an analog signal combiner and a dynamic latch. The analog signal combiner is configured to receive an input analog signal and an input reference signal, and generate an analog output signal by combining the input analog signal and the input reference signal. The dynamic latch is configured to receive the analog output signal and a clock signal, and generate a digital output signal.

## Description

### TECHNICAL FIELD

The present disclosure relates to a comparator, and particularly to a comparator used in an analog-to-digital converter.

### BACKGROUND

Clock and data recovery systems are widely used in communication devices, network devices, etc. to recover clock and data from an analog signal. Such systems typically use an analog-to-digital converter (ADC) equipped with high-speed samplers (e.g., dynamic comparators) to convert an input analog signal based on a reference signal and a clock signal into an output digital signal at an optimum bit error rate (BER). In the ADC, many such samplers are used to obtain various samples of the analog signal at the same time.

However, the analog signal may be subject to noise such as kickback noise or power fluctuation due to a clock signal provided to a dynamic comparator and the output signal generated by the comparator. For example, when power fluctuation is caused by a clock signal fluctuating between high and low signals, the input analog signal may be subject to kickback noise, thereby leading to an incorrect digital output and thus reducing the accuracy of the comparator and the analog-to-digital conversion. When a plurality of dynamic comparators are connected to one analog input signal, the noise from multiple comparators may further degrade the analog input signal.

### SUMMARY

The present disclosure provides a hybrid comparator, an analog-to-digital converter including the hybrid comparator, and a method for generating a digital output signal from an analog signal.

According to an aspect of the present disclosure, a hybrid comparator includes an analog signal combiner and a dynamic latch. The analog signal combiner is configured to receive an input analog signal and an input reference signal, and generate an analog output signal by combining the input analog signal and the input reference signal. The dynamic latch is configured to receive the analog output signal and a clock signal, and generate a digital output signal. The analog signal combiner is operable without any clock signal. The dynamic latch generates the digital output signal from the analog input signal based on the clock signal.

According to another aspect of the present disclosure, an analog-to-digital converter includes a plurality of hybrid comparators configured to receive an input analog signal. Each hybrid comparator includes an analog signal combiner operable without any clock signal and configured to receive the input analog signal and an input reference signal, and generate an analog output signal by combining the input analog signal and the input reference signal. Further, each hybrid comparator includes a dynamic latch configured to receive the analog output signal and a clock signal, and generate a digital output signal based on the clock signal.

According to another aspect of the present disclosure, a method for generating a digital output signal from an analog signal is disclosed. The method includes: receiving, by an analog signal combiner, the analog signal and an input reference signal without any clock signal; combining, by the analog signal combiner, the analog signal and the reference signal without any clock signal to generate an analog output signal; receiving, by a dynamic latch, the analog output signal and a clock signal; and generating, by the dynamic latch, the digital output signal from the analog input signal based on the clock signal. The method may further include latching the digital output signal for output. The analog signal combiner may be isolated from the clock signal.

According to one embodiment of the present disclosure, the analog signal combiner includes an input stage and a load circuit. The input stage may include at least two pairs of differential transistors. One pair of differential transistors may be configured to receive an input differential signal of the input analog signal and the other pair of differential transistors may be configured to receive a reference differential signal of the input reference signal such that the analog signal combiner combines the input differential signal and the reference differential signal to generate an analog output differential signal as the analog output signal. Source terminals of the two pairs of differential transistors may be coupled to one another.

According to one embodiment of the present disclosure, the input analog signal includes first and second input analog signals and the input reference signal includes first and second input reference signals. Further, the input stage may include at least two pairs of differential transistors. One pair of differential transistors may be configured to receive the first input analog signal and the first input reference signal, and the other pair of differential transistors may be configured to receive the second input analog signal and the second input reference signal so as to generate an analog output differential signal as the analog output signal. Source terminals of the two pairs of differential transistors may be coupled to one another.

According to one embodiment of the present disclosure, the analog output signal may include an analog output differential signal. Further, the dynamic latch may receive the analog output differential signal to generate the digital output signal according to the clock signal.

### BRIEF DESCRIPTION OF THE DRAWINGS

Embodiments of the inventive aspects of this disclosure will be understood with reference to the following detailed description, when read in conjunction with the accompanying drawings.
**FIG. 1** illustrates an analog-to-digital converter configured to convert an input analog signal into output digital signal according to one embodiment of the present disclosure.
**FIG. 2** illustrates an exemplary hybrid comparator according to one embodiment of the present disclosure.
**FIG. 3** illustrates a circuit diagram of an exemplary analog signal combiner according to one embodiment of the present disclosure.
**FIG. 4** illustrates a circuit diagram of a dynamic latch according to one embodiment of the present disclosure.
**FIG. 5A** illustrates a timing diagram showing an operation of the analog signal combiner of the hybrid comparator according to one embodiment of the present disclosure.
**FIG. 5B** illustrates a timing diagram showing an operation of the dynamic latch according to one embodiment of the present disclosure.
**FIGS. 6A and 6B** are PAM4 Eye diagrams of input analog signals of a conventional dynamic comparator and the hybrid comparator according to the present disclosure, respectively.
**FIG. 7** is a flow chart illustrating a method for generating a digital output signal from an analog signal using the hybrid comparator according to the present disclosure.
**FIGS. 8A to 8E** illustrate exemplary load circuits that may be used in place of the load circuit in the analog signal combiner illustrated in FIG. 3 according to some embodiments of the present disclosure.
**FIGS. 9A to 9C** illustrate exemplary input stages which may be used in place of the input stage in the analog signal combiner illustrated in FIG. 3 according to some embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the inventive aspects of this disclosure. However, it will be apparent to one of ordinary skill in the art that the inventive aspects of this disclosure may be practiced without these specific details. In other instances, well-known methods, procedures, systems, and components have not been described in detail so as not to unnecessarily obscure aspects of the various embodiments.

In the present disclosure, terms including technical or scientific terms, may have meanings that are generally understood by those ordinarily skilled in the art to which this disclosure belongs, unless otherwise defined.

In the present disclosure, the expressions "A include B," "A may include B," "A is provided with B," "A may be provided with B," "A have B," "A may have B," and the like, mean that corresponding features (e.g., functions, operations, or components, etc.) are present, but do not exclude the presence of other additional features. That is, such expressions should be understood as open-ended terms that include the possibility of including other embodiments.

In the present disclosure, the singular of an expression may include the meaning of the plural of the expression unless otherwise indicated in the context clearly dictates otherwise, and the same applies to singular forms of expressions as set forth in the claims. In the present disclosure, the expressions "1st," "2nd," "first," "second," and the like are used to distinguish one object from another in referring to plural same objects unless otherwise indicated in the context, and do not limit the order or importance of the objects.

In the present disclosure, the expressions "A, B and C," "A, B or C," "A, B and/or C," "at least one of A, B, and C," "at least one of A, B, or C," "at least one of A, B, and/or C," and so on may be used to refer to each listed item or any possible combination of the listed items may be provided. For example, the expression "at least one of A and B" may be used to refer to all of (1) A, (2) B, and (3) A and B.

In the present disclosure, the expression "based on..." is used to describe one or more factors that affect the action or operation of a decision or determination, described in a phrase or sentence in which the expression is contained, and does not exclude additional factors that influence the action or operation of the corresponding decisions or determination.

In the present disclosure, the expression that a component (e.g., a first component) is "connected" or "coupled" to another component (e.g., a second component) may mean that the first component is connected or coupled to the second component not only directly, but also via another new component (e.g., a third component).

In the present disclosure, the expression "configured to..." is intended to encompass, depending on the context, the meanings of "set to...," "having performance of...," "altered to...," "made to...," and "enabled to...," and the like. The corresponding expression is not limited to the meaning "specifically designed in hardware." For example, a processor configured to perform a specific operation may mean a generic-purpose processor that can perform the specific operation by executing software.

Various embodiments of the present disclosure will now be described with reference to the accompanying drawings. In the accompanying drawings and the descriptions of the drawings, substantially equivalent elements may be given the same reference numerals. In the following description of the various embodiments, a description of the same or corresponding components may be omitted. However, this does not mean that the components are not included in the embodiment.

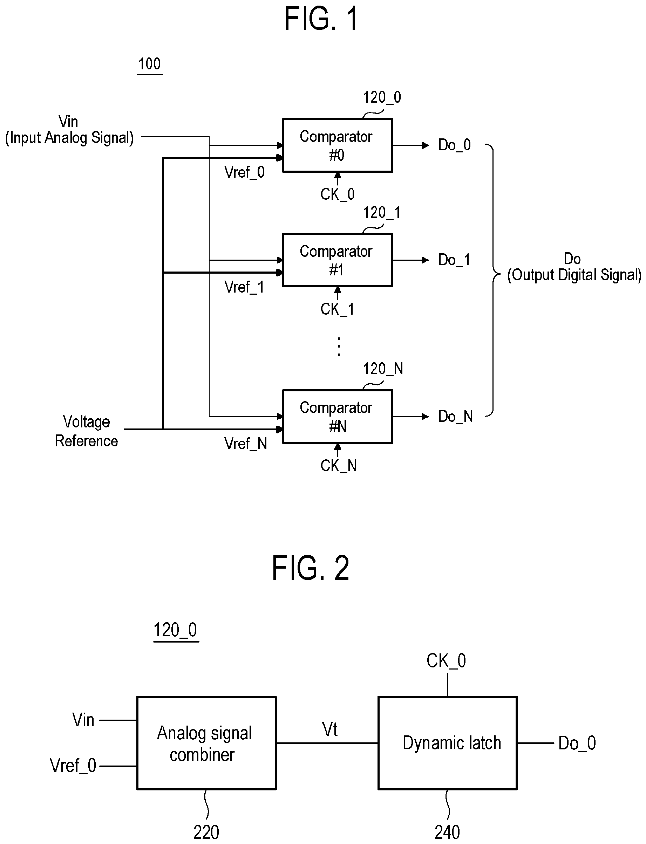

**FIG. 1** illustrates one embodiment of an analog-to-digital converter (ADC) 100 configured to convert an input analog signal Vin into an output digital signal Do according to one embodiment of the present disclosure. The ADC 100 may be configured to receive the input analog signal Vin (e.g., a voltage signal), a reference signal Vref (e.g., a voltage signal), and a clock signal. The ADC 100 includes a plurality of hybrid comparators 120_0, 120_1, ..., 120_N. As inputs, the hybrid comparators 120_0 to 120_N are configured to receive the input analog signal Vin, the reference signal Vref including Vref_0 to Vref _N, respectively, and the clock signal CK including CK_0, CK_1,..., CK_N, respectively, and generate output digital signals Do_0 to Do_N, respectively, which collectively represent an (N+1)-bit digital output Do. The reference signal Vref may be generated from a voltage reference device, which may be provided within or outside the ADC 100. Although the ADC 100 is configured to receive the input analog signal Vin and reference signals as voltage signals, the ADC 100 may also be configured to receive the input analog signal and reference signals as current signals.

The hybrid comparators 120_0 to 120_N may be substantially the same as one another in structure and function. Thus, the hybrid comparator 120_0 will be described as an example of the hybrid comparators. As illustrated in FIG. 1, the hybrid comparator 120_0 may be configured to compare the input analog signal Vin with the reference signal Vref_0, and generate the output digital signal Do_0 based on the clock signal CK_0. Other hybrid comparators 120_1 to 120_N may also operate in a similar manner using reference signals Vref_1 to Vref_N, respectively, and clock signals CK_1 to CK_N, respectively.

Although the comparators 120_0 to 120_N are configured to receive the reference signals Vref_0 to Vref _N, respectively, the reference signals Vref_0 to Vref_N may be identical or substantially the same as one another. In one embodiment, the clock signals CK_0 to CK_N may have different clock frequencies so that the input analog signal Vin is sampled at the different clock frequencies by the hybrid comparators 120_0 to 120_N. Further, at least some of clock signals CK_0 to CK_N may have different frequencies than the remaining of clock signals CK_0, CK_1,..., CK_N. In another embodiment, the clock signals CK_0 to CK_N may have the same clock frequency so as to sample the input analog signal Vin at the same clock frequency.

**FIG. 2** illustrates a block diagram of the hybrid comparator 120_0 according to one embodiment of the present disclosure. In this embodiment, the hybrid comparator 120_0 includes an analog signal combiner 220 and a dynamic latch 240. The analog signal combiner 220 is configured to combine the input analog signal Vin and the reference signal Vref and generate a merged output analog signal Vt. In some embodiments, the hybrid comparator 200 may also amplify the merged signal of the input analog signal Vin and the reference signal Vref.

In the hybrid comparators 120_0, the analog signal combiner 220 is configured to generate the merged output analog signal Vt, without using any clock signal. That is, the analog signal combiner 220 is not provided with or operable with any clock or clock signal and thus is isolated from a clock signal or an effect of such clock signal. Since no clock signal is used by the analog signal combiner 220 to generate the output analog signal Vt, the input analog signal Vin are not affected by kickback noise due to a clock signal or an output signal Vt generated based on a clock signal. Thus, the output analog signal Vt generated by the analog signal combiner 220 without any clock signal may represent the merged signal of the input analog signal Vin and the reference signal Vref in a more accurate manner.

In the hybrid comparator 120_0, the dynamic latch 240 is configured to receive the combined output analog signal Vt and the clock signal CK_0. Based on the clock signal CK_0, the dynamic latch 240 may sample and amplify the merged output analog signal Vt to generate the output digital bit signal Do_0. In this manner, the input analog signal Vin and the reference signal Vref may be first combined and amplified by the analog signal combiner 220 without using a clock signal, and the merged analog signal Vt may be provided to the dynamic latch 240 to be digitized based on the clock signal.

Accordingly, the hybrid comparator 200 includes an analog stage where the input analog signal Vin and the reference signal Vref are first merged and amplified by the analog signal combiner 220 without using any clock signal, and a digital stage where the dynamic latch 240 generates a digitized output of the merged analog signal Vt using a clock signal. Since the input analog signal not subject to no kickback noise caused by a clock signal, the hybrid comparator may thus generate a more accurate digital output that is free from such kickback noise.

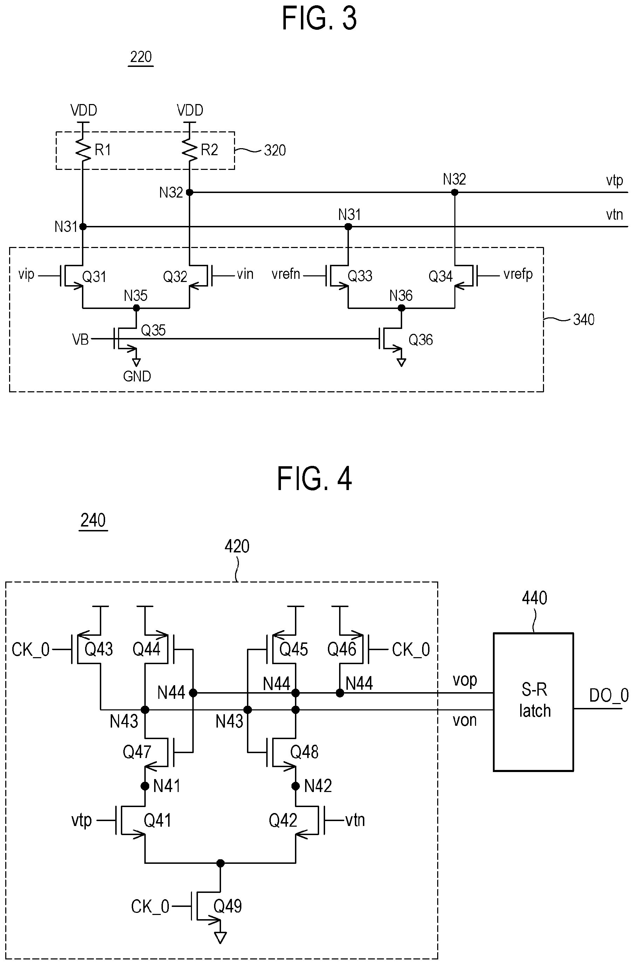

**FIG. 3** illustrates an exemplary circuit diagram of the analog signal combiner 220 according to one embodiment of the present disclosure. The analog signal combiner 220 includes a load circuit 320 and an input stage 340 coupled to the load circuit 320. The load circuit 320 may be coupled to a voltage source (not shown) for providing a power supply voltage VDD at one or more nodes, while being coupled to the input stage 340 at other nodes. As shown in FIG. 3, the load circuit 320 may include two resistors R1 and R2, each of which has one end coupled to the power supply voltage VDD and the other end coupled to the input stage 340 at nodes N31 or N32 as illustrated in FIG. 3.

The input stage 340 may include at least two pairs of differential transistors for receiving the input analog signal Vin in the form of a differential input signals vip and vin, which may be an inverted voltage signal of vip, and the input reference voltage signal Vref in the form of a differential reference voltage signals vrefp and vrefn, which may be an inverted voltage signal of vrefp. In the illustrated embodiment, the input stage 340 may include a first pair of differential transistor Q31 and Q32 for receiving the differential voltage input signals vip and vin, respectively. For example, as shown in FIG. 3, the input voltage vip is provided to a gate terminal of the transistor Q31, while the voltage signal vin may be provided to a gate terminal of the transistor Q32. Drain terminals of the first pair of differential transistor Q31 and Q32 may be coupled to the load circuit 320 at node N31 and N32, respectively. Further, source terminals of the first pair of differential transistor Q31 and Q32 may be coupled to each other at node N35. A bias transistor Q35 may be coupled to node N35 at its drain terminal and to a ground terminal GND at its source terminal, and receive a bias voltage VB at its gate terminal.

The input stage 340 may further include a second pair of differential transistors Q33 and Q34 for receiving the differential reference voltage vrefn and vrefp, respectively, at gate terminals thereof. Further, drain terminals of the transistors Q33 and Q34 are coupled to the load circuit 320 through nodes N31 and N32, respectively. In addition, source terminals of the pair of transistors Q33 and Q34 may be coupled to each other at node N36. A bias transistor Q36 may be coupled to node N36 at is drain terminal and to a ground GND at its source terminal, and receive the bias voltage VB at its gate terminal.

In the input stage 340, the two pairs of transistors for receiving the input analog signal Vin (e.g., vip and vin) and the reference signal Vref (e.g., vrefp and vrefn) are configured to generate a merged signal of the input analog signal Vin and the reference signal Vref. For example, the drain terminal of the transistor Q31 for receiving the input analog voltage vip and the drain terminal of the transistor Q33 for receiving the reference voltage vrefn may be connected at node N31. Further, the drain terminal of the transistor Q32 for receiving the input analog voltage vin and the drain terminal of the transistor Q34 for receiving the reference signal voltage vrefp may be connected at node N32. In this configuration, the output voltage signal Vt including differential output voltage signals vtn and vtp can be generated at nodes N31 and N32, respectively.

The analog signal combiner 300 may operate to merge the input differential voltage signals vip and vin and the reference differential voltage signals vrefp and vrefn. Specifically, a current that flows through the resistor R1 is a combination of a drain current I_{D1} of the transistor Q31 and a drain current I_{D3} of the transistor Q33. Similarly, a current that flows through the resistor R2 is a combination of a drain current I_{D2} of the transistor Q32 and a drain current I_{D4} of the transistor Q34. Accordingly, when the input differential voltage signals vip and vin and the reference differential voltage signals verfn and vrefp are provided to the transistors Q31, Q32, Q33, and Q34, respectively, the drain currents I_{D1}, I_{D2}, I_{D3}, I_{D4} are drawn and the analog signal combiner 300 outputs the differential output signal Vt (i.e., vtp - vtn) corresponding to the merged signal of the input differential voltage signal and the differential reference voltage signal at the output nodes N32 and N31, respectively.

When the input voltage vip provided at the gate terminal of the transistor Q31 is higher than the input voltage vin provided at the gate terminal of the transistor Q32, the drain current I_{D1} of the transistor Q31 increases, thereby decreasing the drain voltage of the transistor Q31, and the drain current I_{D2} of the transistor Q32 decreases, thereby increasing the drain voltage of the transistor Q32. Conversely, when the input voltage vip provided at the gate terminal of the transistor Q31 is lower than the input voltage vin provided at the gate terminal of the transistor Q32, the drain current I_{D1} of the transistor Q31 decreases, thereby increasing the drain voltage of the transistor Q31, and the drain current I_{D2} of the transistor Q32 increases, thereby decreasing the drain voltage of the transistor Q32. Thus, the difference between the input differential voltages causes a difference in the drain currents of the first pair of the differential transistors Q31 and Q32, thereby resulting in a differential output signal that is proportional to the difference between the differential input signals vip and vin.

Similarly, the second pair of differential transistor Q33 and Q34 may operate to generate the differential output signals according to a difference in the differential reference signals vrefp and vrefn. Thus, with the second pair of differential transistors Q33 and Q34 coupled to the first pair of differential transistors Q31 and Q33, the analog signal combiner may generate the merged differential analog signal Vt (= vtp - vtn) indicating a difference between Vin and Vref, i.e., Vin (=vip - vin) - Vref (=vrefp - vrefn).

In one embodiment, the analog signal combiner 300 may be further configured to amplify the difference between the input differential voltage signals vip and vin and the difference between the differential reference signals. In some embodiments, the analog signal combiner 300 may have a gain G, which may be adjusted based on a transistor gain, the resistance of the load circuit 320, etc.

The analog signal combiner 220 is thus configured as an analog circuit without any clock signal. Accordingly, generating the merged differential analog signal Vt in response to the input analog signal Vin is substantially free from kickback noise due to a clock signal.

In some embodiments, each pair of the differential transistors Q31-Q32 and Q33-Q34 may include transistors having substantially symmetrical component characteristics. The transistors Q31 to Q34 in the analog signal combiner 220 may be metal-oxide-semiconductor field-effect-transistors (MOSFETs) such as NMOS or PMOS transistors. The transistors, however, are not limited thereto, and any other types of transistor may be used for the differential transistors. Further, although FIG. 3 illustrates using NMOS transistors for the bias transistors Q35 and Q36, a bias circuit using other types of transistors and/or electrical elements may be used in place of the bias transistors Q35 and Q36 as long as a current is provided between node N35 and the ground GND and between node N36 and the ground GND.

**FIG. 4** illustrates an exemplary circuit diagram of the dynamic latch 240 shown in FIG. 2 according to one embodiment of the present disclosure. In the illustrated embodiment, the dynamic latch 240 may include a clocked latch 420 and an S-R latch 440 cascaded to the clocked latch 420. The clocked latch 420 may be coupled to receive the output analog voltage signal Vt (e.g., the output analog different voltage signals vtp and vtn), which is the merged signal of the input analog differential voltage and the reference voltage, from the analog signal combiner 220. The clocked latch 420 may include a pair of differential transistors Q41 and Q42, two cross-coupled pairs of transistor Q43-Q44 and Q45-46, precharged switches Q47 and Q48, and a tail current source transistor Q49. The pair of differential transistors Q41 and Q42 may receive the output analog differential voltages vtp and vtn from the analog signal combiner 220. The precharged switches Q47 and Q48 may be coupled to the transistor pairs Q43-Q44 and Q45-46 at nodes N43 and N44, respectively. The precharged switches Q47 and Q48 may operate according a clock signal CK_0. The tail current source transistor Q49 may also receive the clock signal CK_0. In one embodiment, a strongARM latch may be used for the clocked latch 420. However, other types of latches using a clock signal may also be used for the clocked latch 420.

The clocked latch 420 may amplify the merged differential voltage signal Vt (e.g., vtp - vtn) received from the analog signal combiner 220 to a VDD or GND level to generate digitized outputs vop and von based on the clock signal CK_0. In the illustrated embodiment of the clocked latch 420, when the clock signal CK_0 is low, the pair of differential transistors Q41 and Q42 may be turned off and the clocked latch 420 is in a precharge phase where nodes N41, N42, N43, and N44 may be precharged to VDD. Then, when the clock signal goes high, the switches Q47 and Q48 may be turned off and the pair of differential transistors Q41 and Q42 may be turned on, thereby drawing a differential current in proportion to the difference between the voltages vtp and vtn.

In this manner, the clocked latch 420 may operate in an amplification phase, which allows the difference between the analog differential voltages vtp and vtn to exceed the difference between the input analog differential voltages vip and vin. When the output analog voltage vtp is higher than the output analog voltage vtn, the transistor Q41 draws more current so that the voltage at node N43 discharges through the transistors Q41, Q43, and Q49. On the other hand, when the output analog voltage vtn is higher than the output analog voltage vtp, the transistor Q2 draws more current so that the voltage at node N44 discharges through the transistors Q42, Q44, and Q49.

Subsequently, as the voltages at nodes N41 and N42 fall to VDD-V_{THN}, the cross-coupled pairs of transistors Q43-Q44 and Q45-46 are turned on, allowing a part of the drain currents of the transistors Q41 and Q42 to flow to nodes N43 and N44. Due to the current drawn by the differential transistors, the output voltages vop and von continue to fall until the voltages reach VDD-V_{THP}, making either of the transistors Q45 and Q46 to turn on. This allows one of the voltages at nodes N43 and 44 to fall to the GND level while the other node reaches the VDD level. Thus, with the positive feedback around the transistors, one output of the clocked latch 420 may reach the VDD level while the other output of the latch may fall to the GND level. When the clocked latch 420 in the precharge phase, the digitized output of the clocked latch 420 may be provided to the S-R latch 440 where the output data is held.

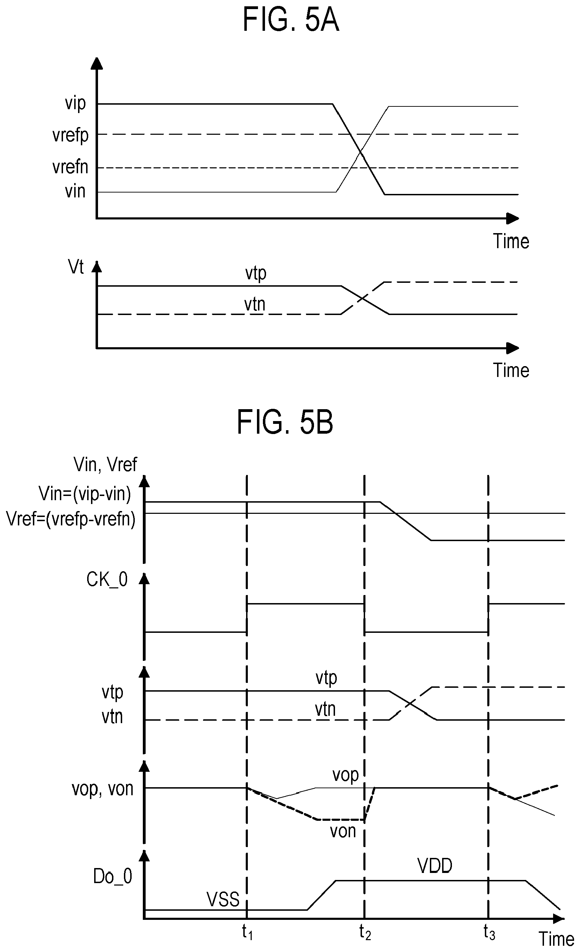

**FIG. 5A** illustrates a timing diagram showing an operation of the analog signal combiner 220 of the hybrid comparator 120_0 according to one embodiment of the present disclosure. In the illustrated embodiment, the analog signal combiner 220 may be provided with the input analog differential voltage Vin (i.e., vip - vin). The input voltage Vin may include first and second input analog voltage signals vip and vin, respectively, where one voltage may be an inverted voltage of the other. In addition, the analog signal combiner 220 may be further provided with the reference differential voltage Vref (i.e., vrefp - vrefn), including first and second differential reference voltage signals vrefp and vrefn, respectively, where one voltage may be an inverted voltage of the other.

The analog signal combiner 220 may generate the output differential analog voltage Vt (i.e., vtp - vtn) by merging the input analog differential voltage Vin and the reference differential voltage Vref. Since the analog signal combiner 220 merges the input analog differential voltage Vin and the reference differential voltage Vref without a clock signal, the generated output signal Vt is also an analog signal. In the illustrated embodiment, the merged analog signal Vt (i.e., vtp - vtn) may be proportional to Vin (= vip - vin) - Vref (= vrefp - vrefn).

As illustrated in FIG. 5A, when the input analog differential signal Vin is higher than the reference differential signal Vref, the first output voltage vtp is higher than the second output voltage vtn. On the other hand, when the input analog differential signal Vin is lower than the reference differential signal Vref, the first output voltage vtp is lower than the second output voltage vtn. In addition, the amplitude of the differential output voltage signals may be proportion to the amplitude of the combined signal of the input analog signal and the reference signal, i.e., Vin (= vip - vin) - Vref (= vrefp - vrefn).

**FIG. 5B** illustrates a timing diagram showing an operation of the dynamic latch 240 according to one embodiment of the present disclosure. The clocked latch 420 of the dynamic latch 240 may receive the output analog differential voltage signal Vt (= vtp - vtn) from the analog signal combiner 220, and further receive the clock signal CK_0. The operation of the dynamic latch 240 begins in the first phase (e.g., before time t₁ in the diagram in FIG. 5B), where the clock signal CK_0 is low. Accordingly, the clocked latch 420 operates in a precharge phase and thus the output voltage signals vop and von of the clocked latch 420 have a voltage value of VDD.

In the second phase (e.g., between time t₁ and time t₂ in the diagram in FIG. 5B), the clock signal CK_0 transitions to high. Thus, the clocked latch 420 generates an output signal according to the received output analog differential voltage Vt. In this embodiment, since the first analog voltage vtp provided to the clocked latch 420 is higher than the second analog voltage vtn provided to the clocked latch 420, the clocked latch 420 generates the output differential voltages including the voltage vop with a voltage value closer to HIGH, and the voltage von with a voltage value closer to LOW. Thus, the values of the output voltage vop and von may be complementary to each other. The S-R latch 440 may be coupled to receive the output differential voltage signals vop and von from the clocked latch 420 and outputs a positive comparator voltage VDD as a digital output Do_0 since the positive output voltage vop is indicative of "1."

In the third phase (e.g., between time t₂ and time t₃ in the diagram in FIG. 5B), the clock signal CK_0 transitions to low again. Accordingly, the clocked latch 420 enters the precharge phase again, and the S-R latch 440 maintains the output Do_0 as VDD. Thus, the output Do_0 is prevented from being changed according to the output voltage from the clocked latch 420 in the precharge phase.

Thereafter, in the fourth phase (e.g., after time t₃ in the diagram in FIG. 5B), the clock signal CK_0 transitions to high (e.g., after time t₃ in the diagram in FIG. 5B). In this case, the first analog voltage vtp provided to the clocked latch 420 is lower than the second analog voltage vtn provided to the clocked latch 420. Thus, the clocked latch 420 generates the output differential voltage including the voltage vop with a voltage value closer to HIGH and the negative output voltage von with a voltage value closer to LOW. Again, the values of the output voltage vop and von can be complementary to each other. The S-R latch 440 may then receive the output differential voltage signals vop and von from the clocked latch 420. In this case, the S-R latch 440 outputs a negative comparator voltage VSS as a digital output Do_0 since the received voltage signal vop is indicative of "0."

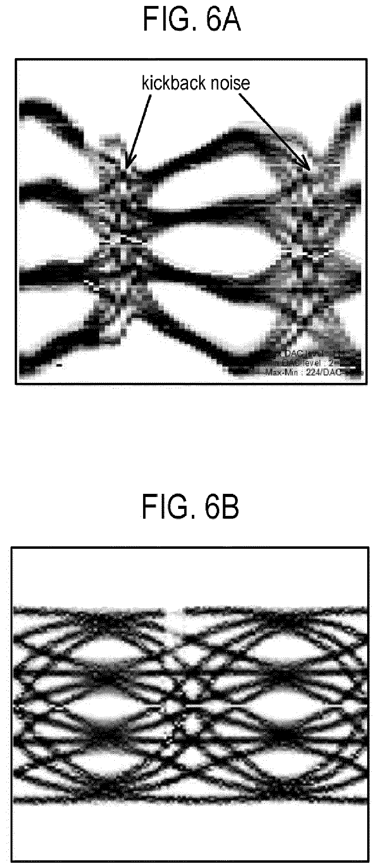

**FIGS. 6A and 6B** are PAM4 Eye diagrams of input analog signals of a conventional dynamic comparator and the hybrid comparator 120_0 according to the present disclosure, respectively.

**FIG. 6A** shows the PAM4 Eye diagram of the input analog signals of 14 conventional dynamic comparators included in an ADC. When the ADC includes many dynamic comparators, an input analog signal provided to one of the dynamic comparators may be affected by the clock signal provided to the same dynamic comparator as well as the clock signals provided to other dynamic comparators in the ADC. As a result, as shown in FIG. 6A, the input analog signals include kickback noise caused by the clock signals provided to the dynamic comparators.

In contrast, in **FIG. 6B****,** the PAM4 Eye diagram of the input analog signals of 14 hybrid comparators shows that the input analog signals are not subject to substantial kickback noise due to a clock signal. As discussed above, in each of the hybrid comparators 120_0 to 120_N, the analog signal combiner 220 first combines the received input analog signal and the reference signal without a clock signal, and then the dynamic latch 240 receives the combined analog signal from the analog signal combiner 220 and generates a digital output based on a clock signal. Thus, the input analog signals are substantially free of kickback noise as shown in FIG. 6B.

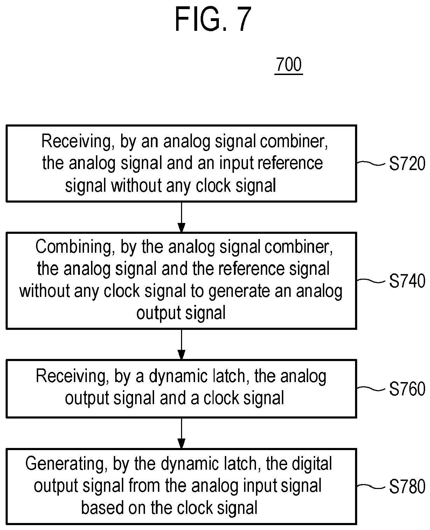

**FIG. 7** is a flow chart illustrating a method 700 for generating a digital output signal from an analog signal using the hybrid comparator 120_0 according to the present disclosure. The method 700 may be performed using any of the various hardware embodiments discussed herein, as well as others that fall within the scope of this disclosure.

In this method 700, the analog signal combiner 220 may receive the analog signal and an input reference signal without any clock signal (S720). In some embodiments, receiving, by the analog signal combiner, the analog signal and the input reference signal (S720) may include receiving an input analog signal Vin in the form of a differential input signals vip and vin, which may be an inverted voltage signal of vip, and the input reference voltage signal Vref in the form of a differential reference voltage signal vrefp and vrefn, which may be an inverted voltage signal of vrefp.

The analog signal combiner 220 may then combine the analog signal and the reference signal without any clock signal to generate an analog output signal (S740). In some embodiments, combining, by the analog signal combiner 220, the analog signal and the reference signal to generate the analog output signal (S740) may include amplifying, by the analog signal combiner 220, the difference between the input analog signal Vin and the input reference voltage signal Vref.

In some embodiments, the analog signal combiner 220 may be electrically isolated from the clock signal by using suitable isolation techniques or devices.

After the analog signal combiner 220 generates the output signal, the dynamic latch 240 may receive the analog output signal and a clock signal (S760). The dynamic latch may then generate a digital output signal from the analog output signal based on the clock signal (S780). In some embodiments, generating the digital output signal by the dynamic latch may include amplifying the analog output signal to either a supply voltage level or a ground voltage level. For example, when the analog output signal received from the analog signal combiner 220 indicates that the input analog signal Vin is higher than the input reference voltage signal Vref, the dynamic latch 240 generates the output signal which is amplified to a supply voltage level. Conversely, when the analog output signal received from the analog signal combiner 220 indicates that the input analog signal Vin is lower than the input reference voltage signal Vref, the dynamic latch 240 generates the output signal which is amplified to a ground voltage level.

In some embodiments, the method 700 may further include latching the digital output signal for output.

Advantageously, the analog signal combiner 220 merges the input analog differential signal with the differential reference signal without using a clock signal and then provides the merged signal to the dynamic latch. Since the merged signal generated without using a clock signal is substantially free from kickback noise, the accuracy of the digital output signal generated from the dynamic latch is enhanced.

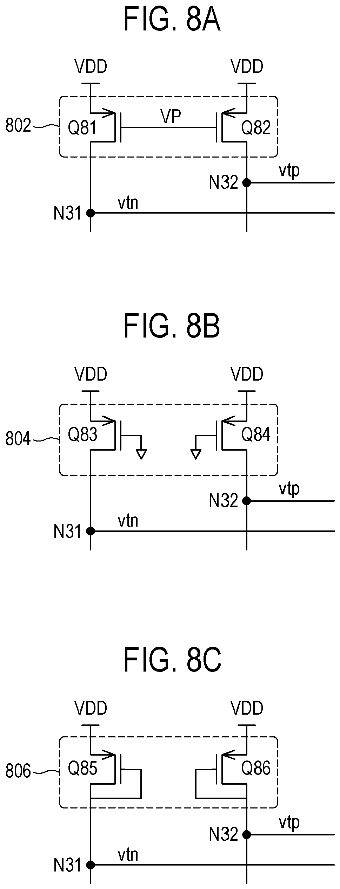

**FIGS. 8A to 8E** illustrate exemplary load circuits 802, 804, 806, 808, and 810, respectively, that may be used in place of the load circuit 320 in the analog signal combiner 220 according to some embodiments of the present disclosure. Although such load circuits 320 and 802 to 810 are illustrated herein, the present disclosure is not limited thereto and load circuits of other suitable configurations may be used in the analog signal combiner 220.

As shown in FIG. 8A, the load circuit 802 may include one or more transistors. For example, the load circuit 802 may include two PMOS transistors Q81 and Q82, each of which has one terminal coupled to VDD and the other terminal coupled to node N31 or N32. Further, the PMOS transistors Q81 and Q82 may be coupled with each other and configured to receive a common voltage VP. However, other types of transistors (e.g., NMOS transistor) may also be used for the load circuit 802.

In another embodiment, the load circuit 804 of FIG. 8B may include one or more linear transistors. For example, the load circuit 804 may include two linear transistors Q83 and Q84, each of which has one terminal coupled to VDD and the other terminal coupled to node N31 or N32.

In a further embodiment, the load circuit 806 of FIG. 8C may include one or more diode-connected transistors. For example, the load circuit 806 may include two diode connected transistors Q85 and Q86, each of which has one terminal coupled to VDD and the other terminal coupled to node N31 or N32.

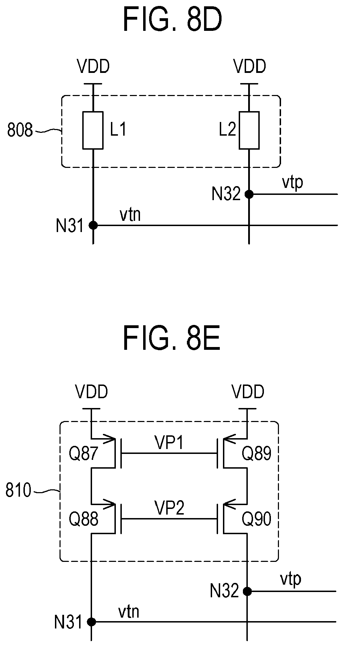

In yet another embodiment, the load circuit 808 of FIG. 8D may include one or more inductors L1 and L2. For example, the load circuit 806 may include two inductors L1 and L2, each of which may have one terminal coupled to VDD and the other terminal coupled to node N31 or N32.

In still another embodiment, the load circuit 810 of FIG. 8E may be configured with a cascade configuration including two transistors. For example, the load circuit 810 may include two pairs of cascade transistors Q87-Q88 and Q89-Q90, each of which has one terminal coupled to VDD and the other terminal coupled to nodes N31 or N32, respectively. Further, as illustrated in FIG. 8E, the gate terminals of the upper transistors Q87 and Q89 may be coupled with each other and configured to receive a voltage VP1, while the gate terminals of the lower transistors Q88 and Q90 may be coupled with each other and configured to receive a voltage VP2.

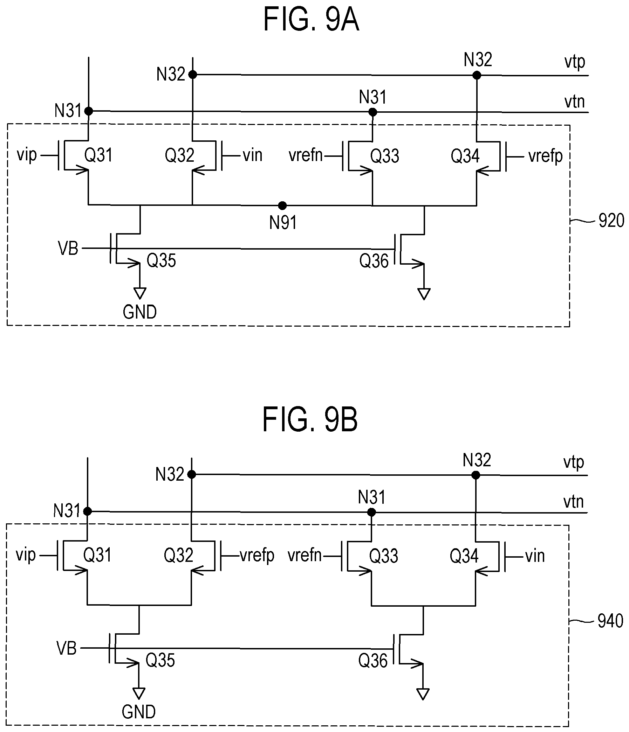

**FIGS. 9A to 9C** illustrate exemplary input stages 920, 940, and 950, respectively, which may be used in place of the input stage 340 in the analog signal combiner 220 according to some embodiments of the present disclosure.

In one embodiment as illustrated in FIG. 9A, the input stage 920 may have the same configuration as the input stage 340 in FIG. 3 except that all source terminals of the two pairs of the differential transistors are coupled together at their source nodes, which are further coupled to the bias transistors. That is, the input stage 920 may include the first and second pairs of differential transistors Q31-Q32 and Q33-Q34 and the bias transistors Q35 and 36. While the first pair of differential transistors Q31 and Q32 receives the input differential analog signals vip and vin, respectively, at gate terminals thereof, the second pair of differential transistors Q33 and Q34 receives the differential reference voltage signals vrefn and vrefp, respectively, at gate terminals thereof. However, unlike the input stage 340 shown in FIG. 3, the source terminals of the first and second pairs of differential transistors Q31-Q32 and Q33-Q34 may be coupled to each other at node N91. The bias transistors Q35 and Q36 may be coupled to node N91 at the drain terminals thereof and to a ground terminal GND at the source terminals thereof, and receive the bias voltage VB at the gate terminals thereof. Since the bias transistors Q35 and 36 serve as a current source as those in the input stage 340, the input stage 920 may also operate in substantially the same manner as the input stage 340 to generate the merged signal of the input analog signal and the reference signal as the output differential analog signals vtn and vtp at nodes N31 and N32, respectively.

In another embodiment as illustrated in FIG. 9B, the input stage 940 may include at least two pairs of differential transistors having the same configuration as that of the two pairs of differential transistors in FIG. 3, but with a difference that the inputs to the transistors Q32 and Q34 are switched therebetween. Specifically, the input stage 940 may include the first and second pairs of differential transistors Q31-Q32 and Q33-Q34, along with the bias transistors Q35 and 36. For example, as shown in FIG. 9B, one pair of differential transistors Q31 and Q32 receives one of the input and reference signals such that the transistor Q31 receives the input voltage vip at its gate terminal, while the transistor Q32 receives the reference voltage signal vrefp at its gate terminal. Further, the other pair of differential transistors Q33 and 34 receives the other of the input and reference signals such that the transistor Q34 receives the input voltage vin at its gate terminal and the transistor Q33 receives the reference voltage signal vrefn at its gate terminal.

In the embodiment shown in FIG. 9B, the first pair of differential transistor is configured to detect the difference between the input analog voltage signal vip and the reference signal vrefp and the second pair of differential transistor is configured to detect the difference between the input analog voltage signal vin and the reference signal vrefn. Then, according to the detected voltage difference between the signals vip - vrefp and the detected voltage difference between the signals vin - vrefn, the currents that flow through the resistors R1 and R2 are drawn so that the output differential signals vtp and vtn can be generated at nodes N32 and N31, respectively . Accordingly, when the analog signal combiner 220 uses the input stage 940 according to the embodiment illustrated in FIG. 9B, the output differential voltage signals vop and von detected at nodes N31 and N32, i.e., Vin (= vip - vin) - Vref (= vrefp - vrefn) are the substantially the same as when the input stage 340 is used.

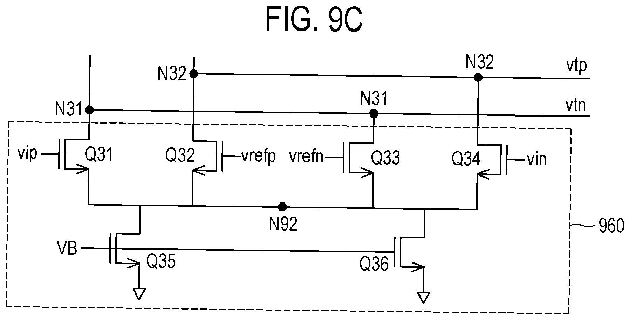

In the embodiment as illustrated in FIG. 9C, the input stage 960 may have the same configuration as that of the input stage 940 shown in FIG. 9B except that all source terminals of the two pairs of the differential transistors Q31-Q32 and Q33-Q34 are coupled together at node N92, which is also coupled to the bias transistors Q35 and Q36. Since the bias transistors Q35 and 36 serve as a current source like the transistors Q35 and Q36 in the input stage 940, the input stage 960 may also operate in substantially the same manner as the input stage 940 to generate the merged signal of the input analog signal and the reference signal as the output differential analog signal vtn and vtp at nodes N31 and N32.

Although various embodiments of the analog signal combiner 220 have been described above, the present disclosure is not limited thereto, and various other embodiments are possible as long as they are configured to generate the combined signal of the input analog signal and the reference signal.

Further, in some embodiments, circuits where NMOS transistors are replaced with PMOS transistors, or vice versa, and connections to ground and supply voltage terminals are interchanged may be used in the hybrid comparators according to the present disclosure. In addition, transistors other than MOS transistors, such as BJTs, may be used in the circuit embodiments in place of MOS transistors.

The descriptions in the present disclosure are provided to enable a person of ordinary skill in the art to make and use the disclosure. Various modifications to the disclosure will be readily apparent to those skilled in the art, and the generic principles defined herein may be applied to other variations without departing from the spirit or scope of the disclosure. Thus, the disclosure is not intended to be limited to the examples described herein but is to be accorded the widest scope consistent with the principles and novel features disclosed herein.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A hybrid comparator, comprising
an analog signal combiner configured to receive an input analog signal and an input reference signal, and generate an analog output signal by combining the input analog signal and the input reference signal; and
a dynamic latch configured to receive the analog output signal and a clock signal, and generate a digital output signal.

2. The hybrid comparator in Claim 1, wherein the analog signal combiner is operable without any clock signal.

3. The hybrid comparator in Claim 1, wherein the dynamic latch generates the digital output signal from the analog output signal based on the clock signal, wherein the analog output signal preferably includes an analog output differential signal and the dynamic latch receives the analog output differential signal to generate the digital output signal according to the clock signal.

4. The hybrid comparator in Claim 1, wherein the analog signal combiner includes:
a load circuit; and
an input stage coupled to the load circuit to generate the analog output signal,
wherein the input stage preferably includes at least two pairs of differential transistors, one pair of differential transistors being configured to receive an input differential signal of the input analog signal and the other pair of differential transistors being configured to receive a reference differential signal of the input reference signal such that the input differential signal and the reference differential signal are combined to generate an analog output differential signal as the analog output signal.

5. The hybrid comparator in Claim 4, wherein the input analog signal includes first and second input analog signals and the input reference signal includes first and second input reference signals, and
wherein the input stage includes at least two pairs of differential transistors, one pair of differential transistors being configured to receive the first input analog signal and the first input reference signal, and the other pair of differential transistors being configured to receive the second input analog signal and the second input reference signal so as to generate an analog output differential signal as the analog output signal, wherein source terminals of the two pairs of differential transistors are preferably coupled to one another.

6. The hybrid comparator in Claim 4, wherein the load circuit comprises at least one of a pair of resistors, a pair of transistors, a pair of diodes, a pair of diode-connected transistors, a pair of cascade transistors, or one or more combinations thereof.

7. An analog-to-digital converter comprising:
a plurality of hybrid comparators configured to receive an input analog signal, each hybrid comparator including:
an analog signal combiner operable without any clock signal and configured to receive the input analog signal and an input reference signal, and generate an analog output signal by combining the input analog signal and the input reference signal; and
a dynamic latch configured to receive the analog output signal and a clock signal, and generate a digital output signal based on the clock signal.

8. The analog-to-digital converter of Claim 7, wherein the analog signal combiner includes:
a load circuit; and
an input stage coupled to the load circuit to generate the analog output signal,
wherein the input stage preferably includes at least two pairs of differential transistors, one pair of differential transistors being configured to receive an input differential signal of the input analog signal and the other pair of differential transistors being configured to receive a reference differential signal of the input reference signal such that the input differential signal and the reference differential signal are combined to generate an analog output differential signal as the analog output signal.

9. The analog-to-digital converter of Claim 8, wherein the input analog signal includes first and second input analog signals and the input reference signal includes first and second input reference signals, and
wherein the input stage includes at least two pairs of differential transistors, one pair of differential transistors being configured to receive the first input analog signal and the first input reference signal, and the other pair of differential transistors being configured to receive the second input analog signal and the second input reference signal so as to generate an analog output differential signal as the analog output signal.

10. The analog-to-digital converter of Claim 8, wherein source terminals of the two pairs of differential transistors are coupled to one another.

11. The analog-to-digital converter of Claim 8, wherein the load circuit comprises at least one of a pair of resistors, a pair of transistors, or a pair of diodes.

12. The analog-to-digital converter of Claim 7, wherein the analog output signal includes an analog output differential signal and the dynamic latch receives the analog output differential signal to generate the digital output signal according to the clock signal.

13. A method for generating a digital output signal from an analog signal, comprising
receiving, by an analog signal combiner, the analog signal and an input reference signal without any clock signal,
combining, by the analog signal combiner, the analog signal and the reference signal without any clock signal to generate an analog output signal; and
receiving, by a dynamic latch, the analog output signal and a clock signal, and generating, by the dynamic latch, the digital output signal from the analog output signal based on the clock signal, wherein generating the digital output signal by the dynamic latch preferably includes amplifying the analog output signal to either a supply voltage level or a ground voltage level.

14. The method of Claim 13, further comprising:
latching the digital output signal for output.

15. The method of Claim 13, wherein the analog signal combiner is isolated from the clock signal.
